**Europäisches Patentamt**

**European Patent Office**

**Office européen des brevets**

(19)

(11) Veröffentlichungsnummer: **0 227 851 B1**

(12) **EUROPÄISCHE PATENTSCHRIFT**

(45) Veröffentlichungstag der Patentschrift: **27.02.91**

(51) Int. Cl.⁵: **G03F 7/20, G03F 1/00**

(21) Anmeldenummer: **85116430.1**

(22) Anmeldetag: **21.12.85**

(54) **Verfahren zum Herstellen eines Photolackmusters.**

(43) Veröffentlichungstag der Anmeldung:
**08.07.87 Patentblatt 87/28**

(45) Bekanntmachung des Hinweises auf die
Patenterteilung:
**27.02.91 Patentblatt 91/09**

(84) Benannte Vertragsstaaten:
**DE FR GB IT**

(56) Entgegenhaltungen:
**DE-A- 2 854 045**
**US-A- 4 308 337**

**IBM TECHNICAL DISCLOSURE BULLETIN,
Band 21, Nr. 12, Mai 1979, Seite 4787, New
York, US; O.R. ABOLAFIA: "Tapered vias in a
photosensitive dielectric film"**

**IBM TECHNICAL DISCLOSURE BULLETIN,
Band 25. Nr. 4, September 1982, Seite 2057,
New York, US; E. COURTENS: "Enhancement
of edge exposure by modified photolithography masks for proximity printing on thick
resists"**

(73) Patentinhaber: **IBM DEUTSCHLAND GMBH
Pascalstrasse 100
D-7000 Stuttgart 80(DE)DE**

Patentinhaber: **International Business Machines Corporation
Old Orchard Road
Armonk, N.Y. 10504(US)FR**

(72) Erfinder: **Moritz, Holger
72 Cherry Blossom Drive
San Jose CA 95123(US)**
Erfinder: **Pietsch, Dieter
Hermannstrasse 6
D-7037 Magstadt(DE)**
Erfinder: **Wüstenhagen, Jürgen, Dr.
Amsterdamer Strasse 7
D-7030 Böblingen(DE)**
Erfinder: **Ziegler, Johanna
Dresdener Strasse 37
D-7032 Sindelfingen(DE)**

(74) Vertreter: **Mönig, Anton, Dipl.-Ing.
IBM Deutschland GmbH Patentwesen und
Urheberrecht Schönaicher Strasse 220
D-7030 Böblingen(DE)**

IBM TECHNICAL DISCLOSURE BULLETIN, Band 23, Nr. 2, Juli 1980, Seiten 826-827, New York, US; J.L. SPEIDELL: " "Trench" elimination from ion etching"

PATENTS ABSTRACTS OF JAPAN, Band 9, Nr. 299 (P-408)[2022], 27. November 1985; & JP - A - 60 135 949

XEROX DISCLOSURE JOURNAL, Band 7, Nr. 4, Juli/August 1982, Seiten 293-294, Stamford, Connecticut, US; R.B. RAUCH: "A double exposure technique for positive resist lift-off"

MICROELECTRONIC ENGINEERING, Band 1, Nr. 4, Dezember 1983, Seiten 295-300, Elsevier Publishers B.V., Amsterdam, NL; K. IS-MAIL: "A novel method for submicron structurization using optical projection lithography"

IBM TECHNICAL DISCLOSURE BULLETIN, Band 18, Nr. 7, Dezember 1975, Seite 2179, New York, US; J.E. KULAK et al.: "Tool for blanket exposure of photopolymer films"

## Beschreibung

Die Erfindung betrifft ein Verfahren zum Herstellen von Mustern aus positivem Photolack, der die angewandte Strahlung wenig absorbiert, wobei eine Schicht aus dem Photolack in einem Projektionsbelichtungsgerät bildmäßig bestrahlt, anschließend erhitzt und schließlich mit einem basischen Entwickler behandelt wird.

Wegen der heute in der Halbleitertechnik erforderlichen kleinen Strukturen (Größenordnung 1 μm) werden zum Erzeugen von Photolackstrukturen Projektionsbelichtungsgeräte hoher Auflösung eingesetzt. Die aufgrund ihrer sonstigen vorteilhaften Eigenschaften eingesetzten Positivlacke haben eine hohe Transparenz für die bei der Projektionsbestrahlung üblicherweise verwendete Strahlung (λ = 435 nm), d.h. daß der Photolack in den bestrahlten Bereichen über seine gesamte Dicke ziemlich gleichmäßig abgebaut wird. Werden die bestrahlten Photolackschichten entwickelt, wobei - um die Entwicklung gut steuern zu können - verdünnte basische Entwicklerlösungen verwendet werden, so haben die erzeugten Öffnungen im Photolack senkrechte Wände. Werden die so erzeugten Photolackmuster als Ätzmasken bei einem nachfolgenden Trockenätzprozess eingesetzt, so überträgt sich die Öffnungsform im Photolackmuster exakt in das geätzte Material, d.h. auch die Löcher im geätzten Material haben senkrechte Wände. Wird in späteren Verfahrensschritten auf diese geätzte Struktur eine Schicht niedergeschlagen, so ergeben sich Probleme, weil die Dicke der aufgebrachten Schicht uneinheitlich und insbesondere im Bereich der Lochwände und der Lochkanten relativ zu dünn ist, was schlechte Stufenbedeckung und Abrisse zur Folge hat. Ein typisches Beispiel dafür sind Metalleitungen mit Schwachstellen am Rand von Kontaktlöchern in Isolierschichten. Die geschilderten Mängel sind verantwortlich für eine erhöhte Ausfallhäufigkeit bei den Bauteilen, die solche Strukturen enthalten.

Es sind Maßnahmen bekannt, die ergriffen werden, um Löcher mit senkrechten Wänden in den geätzten Strukturen zu verhindern. So ist es z.B. bekannt, das Ätzen in einer Vielzahl von Schritten durchzuführen, wobei durch eine schrittweise Aufweitung der Ätzmaske Stufen in die Wände der Löcher geätzt werden (sog. "Konturätzen"). Praktisch wird dadurch eine Abschrägung der Lochwände erreicht und verhindert, daß beim Aufbringen einer Schicht die eben geschilderten Schwierigkeiten auftreten. Allerdings ist der bekannte Prozess langwierig und kompliziert und dadurch teuer und außerdem schlecht reproduzierbar.

Bei einem anderen bekannten Verfahren werden vor dem Ätzen die Wände der Öffnungen im Photolack abgeschrägt, indem nach dem Entwickeln die Photolackstruktur erhitzt wird, was ein Weichwerden und Verfließen des Photolacks bewirkt. Dadurch werden die Photolackkanten abgerundet und die Wände der Öffnungen werden schräg, wobei unter "schräg" verstanden wird, daß das Loch unten, wo es sich zu dem zu ätzenden Material hin öffnet, kleinere Abmessungen hat als oben. Nachteilig ist dabei insbesondere, daß die Kantenwinkel der Wände von dem Lochdurchmesser und der Packungsdichte in der Umgebung des Lochs abhängen. Die Schräge der Wände der Öffnungen im Photolackmuster überträgt sich auch auf die im geätzten Material entstandenen Löcher. Dieses Verfahren ist zwar wesentlich einfacher als das zuerst genannte bekannte Verfahren, aber auch dieses Verfahren ist zu ungenau, um Löcher mit sehr kleinen Abmessungen innerhalb enger Toleranzen reproduzierbar herzustellen.

In der DE-OS 2 645 081 ist ein weiteres Verfahren zum Herstellen von Photolackmustern mit schrägen Wänden in den Öffnungen beschrieben. Dabei wird

1. das zur Bestrahlung verwendete UV-Licht defokussiert oder dekollimiert und
2. ein geringer Abstand zwischen Maske und Photolackschicht eingehalten und/oder
3. eine dicke (> 2 μm) Photolackschicht verwendet und
4. eine disperse (nicht kollimierte) Lichtquelle angewandt.

Dieses Verfahren hat allerdings den Nachteil, daß das übertragene Muster unscharf und nicht gut reproduzierbar ist.

Es ist deshalb die Aufgabe der Erfindung, ein einfaches, in einer Fertigung einsetzbares Verfahren zum reproduzierbaren, mustertreuen Erzeugen eines Musters mit Öffnungen, deren Wände schräg mit festgelegtem Neigungswinkel sind aus positivem Photolack, in dem die angewandte Strahlung wenig absorbiert wird, mittels bildmäßiger Projektionsbestrahlung und Entwicklung anzugeben.

Diese Aufgabe wird mit einem Verfahren der eingangs genannten Art mit den Merkmalen des kennzeichnenden Teils des Patentanspruchs 1 gelöst.

Mit dem erfindungsgemäßen Verfahren werden auch Strukturen im μm-Bereich mit festgelegtem Neigungswinkel der Öffnungswandungen reproduzierbar erzeugt. Dabei werden dieselben einfachen Prozesse eingesetzt, welche zur Herstellung von Lackstrukturen mit senkrechten Öffnungswänden verwendet werden. Die zusätzliche Bestrahlung kann im selben Arbeitsgang wie die bildmäßige Bestrahlung erfolgen und benötigt dabei höchstens eine unwesentlich längere Zeit. Wird die erfindungsgemäß hergestellte

EP 0 227 851 B1

Photolackstruktur als Ätzmaske verwendet, so lassen sich auf der geätzten, Löcher mit geneigten Wänden aufweisenden Struktur Schichten einheitlicher Dicke niederschlagen, die nicht die oben angegebenen Probleme verursachen.

In der US-A-4 308 337 wird ein Verfahren zum Eliminieren von Überhängen aus Photolack an den Wänden von Photolackmustern beschrieben, bei dem die Photolackschicht außer bildmäßig entsprechend dem gewünschten Muster auch noch in der Weise ganzflächig bestrahlt wird, daß eine Oberflächenschicht des Photolacks, welche so dick ist, daß sie den Überhang umfassen würde, löslich gemacht wird. Bei der ganzflächigen Bestrahlung wird dabei mit einem Licht bestrahlt, welches einen hohen UV-Anteil hat, damit in dem Photolack stark absorbiert wird und deshalb nur wenig eindringen kann. D. h., daß anders als bei dem erfindungsgemäßen Verfahren die Neigung der Wände in dem fertigen Photolackmuster durch die ganzflächige Bestrahlung nicht beeinflußt wird.

Es ist vorteilhaft, wenn die Photolackschicht zusätzlich ganz flächig bestrahlt wird. Die zusätzliche ganzflächige Bestrahlung benötigt nur einen Bruchteil der Zeit, welche bei der bildmäßigen Bestrahlung angewandt wird. Die ganzflächige Bestrahlung erzeugt außerdem keine Defekte und kann vollautomatisch durchgeführt werden.

In vorteilhafter Weise wird der Neigungswinkel der Wände in den Öffnungen der entwickelten Photolackschicht gesteuert über das Verhältnis der Intensitäten von bildmäßiger und ganzflächiger Bestrahlung, wobei das optimale Verhältnis der Intensität zwischen 1,5 und 13 liegt.

Bei einer weiteren vorteilhaften Ausgestaltung des erfindungsgemäßen Verfahrens wird zum bildmäßigen Bestrahlen eine Projektionsmaske verwendet, bei der durch eine entsprechende Ausgestaltung der Randgebiete der transparenten Bereiche in der Projektionsmaske eine auf die Photolackschicht einwirkende Streustrahlung erzeugt wird. Es ist dabei zwar eine Veränderung der Maske für das bildmäßige Bestrahlen erforderlich, jedoch ist eine solche Änderung - insbesondere mit den heutigen Mitteln der programmgesteuerten Maskenerzeugung - einfach. Bei Verwendung dieser geänderten Maske erfolgt die bildmäßige Bestrahlung und die Bestrahlung der Schichtbereiche, die an die bildmäßigen Bestrahlung ausgesetzten Bereiche angrenzen, gleichzeitig, d.h. der Prozessablauf ist gleich wie bei dem bekannten Verfahren, bei dem Öffnungen in der Lackschicht mit senkrechten Wänden erzeugt werden. Bei der genannten zweiten Ausgestaltung des erfindungsgemäßen Verfahrens ist es vorteilhaft, wenn eine Projektionsmaske verwendet wird, bei der entweder die bildmäßig zu übertragenden transparenten Bereiche in einem festgelegten Abstand mit einem transparenten Ring festgelegter Breite umgeben sind, der bei der Projektion nicht mehr aufgelöst wird oder bei welcher die Ränder der zu projizierenden transparenten Bereiche sternförmig ausgebuchtet sind, wobei die Ausbuchtungen so ausgebildet sind, daß auch sie bei der Projektion nicht mehr aufgelöst werden.

Weitere vorteilhafte Ausführungsformen des erfindungsgemäßen Verfahrens sind in den Unteransprüchen aufgeführt.

Die Erfindung wird anhand von durch Zeichnungen erläuterten Ausführungsbeispielen beschrieben. Es zeigen

Fig. 1A in einer schematischen Querschnittsdarstellung einen Ausschnitt aus einer Projektionsmaske und einer gemäß dem Stand der Technik unter Verwendung der Projektionsmaske hergestellten Photolackstruktur,

Fig. 1B und 1C in Diagrammen die Bestrahlungsintensität (I) und die daraus resultierende Löslichkeit (L) des bestrahlten Photolacks entlang des in der Fig. 1A gezeigten Querschnitts,

Fig. 2A in einer schematischen Querschnittsdarstellung einen Ausschnitt aus einer Projektionsmaske und einer gemäß einer Ausführungsform des erfindungsgemäßen Verfahrens hergestellten Photolackstruktur,

Fig. 2B und 2C in Diagrammen die Bestrahlungsintensitäten der bildmäßigen und der ganzflächigen Bestrahlung und die daraus resultierende Löslichkeit des Photolacks entlang des in Fig. 2A gezeigten Querschnitts,

Fig. 3 bis 5 Schnitte durch die eine Wand von Öffnungen in Photolackstrukturen, welche gemäß der Ausgestaltung des erfindungsgemäßen Verfahrens, bei der zusätzlich ganzflächig bestrahlt wird, hergestellt worden ist, wobei das Verhältnis der Intensitäten von bildmäßiger und ganzflächiger Bestrahlung unterschiedlich war, und

Fig. 6 und 7 in schematischer Darstellung Ausbildungen zweier transparenter Bereiche von Projektionsmasken, welche bei der zweiten Ausgestaltung des erfindungsgemäßen Verfahrens eingesetzt werden.

Zur Verdeutlichung des erfindungsgemäßen Verfahrens soll zunächst anhand der Fig. 1A bis 1C auf den nächstliegenden Stand der Technik eingegangen werden. Ausgegangen wird dabei von einer auf einem Substrat 3 aufgebrachten Photolackschicht 4, in der die angewandte Strahlung wenig absorbiert, wird, sodaß der der Strahlung ausgesetzte Photolack in Strahlrichtung gleichmäßig abgebaut wird. Da in der Photolackschicht 4 kleine Strukturen (Größenordnung 1μm) erzeugt werden sollen, werden Projektionsbelichtungsge-

4

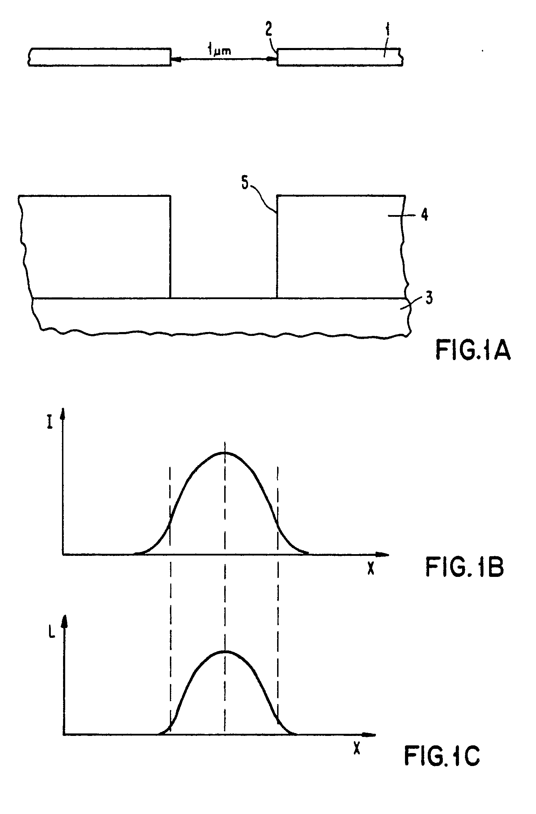

räte mit hoher Auslösung zum Bestrahlen des Photolacks eingesetzt. (Anders als in der Fig. 1A der besseren Anschaulichkeit halber gezeichnet, wird beim Projektionsbelichten das Muster in der Projektionsmaske üblicherweise um den Faktor 5 verkleinert auf die Photolackschicht übertragen.) Die Strahlung wird dabei durch die Maske 1 und eine Linse hindurch auf die Photolackschicht 4 projiziert. Die Strahlung wird an den Kanten das Maskenmusters 2 gebeugt, mit der Folge, daß die Intensität über den bestrahlten Bereich nicht einheitlich sondern die in der Fig. 1B gezeigte Verteilung hat. Die Fig. 1B zeigt, daß in den von der Maske 1 abgeschatteten Photolackgebieten die eingestrahlte Strahlungsmenge gering ist. Da die Maske 1 verschieden große Musterbereiche enthält, muß, um die Maßhaltigkeit zu gewährleisten, ein nur schwach konzentrierter Entwickler verwendet werden. Ein solcher Entwickler vermag Photolackbereiche, welche nur mit einer Intensität bestrahlt worden sind, welche unter einem konzentrationsabhängigen Wert liegt, nicht mehr zu lösen (Fig. 1C). Darauf ist es zurückzuführen, daß die von der Projektionsmaske 1 abgedeckten Photolackgebiete nicht entwickelt werden und daß infolgedessen - wie die Fig. 1A zeigt - Öffnungen in der Photolackschicht 4 mit senkrechten Wänden erzeugt werden.

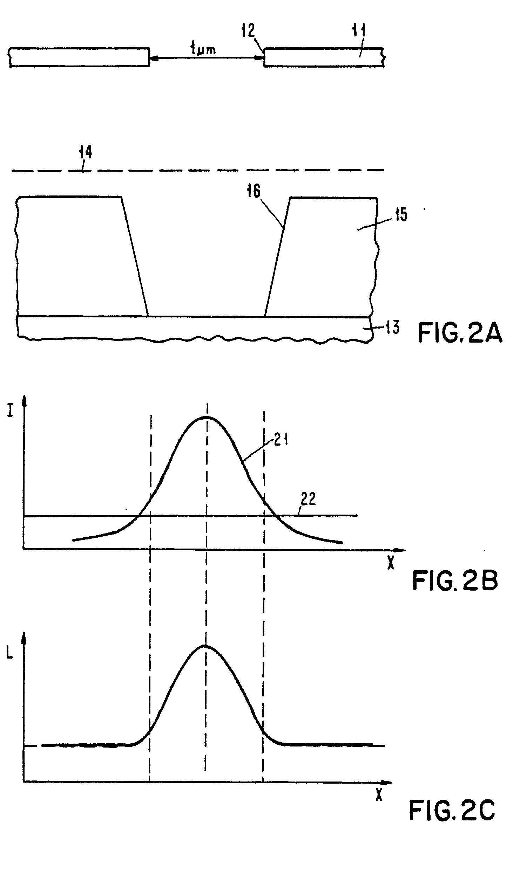

Durch das erfindungsgemäße Verfahren wird erreicht, daß die Wände der Öffnungen nicht senkrecht, sondern geneigt sind, d.h. daß die Öffnungen oben weiter sind als unten, wo sie an das Substrat grenzen. Bei der einen Ausgestaltung des erfindungsgemäßen Verfahrens, die nun anhand der Fig. 2A bis 2C veranschaulicht werden soll, wird im Unterschied zum Stand der Technik zusätzlich zu der bildmäßigen Bestrahlung noch ganzflächig bestrahlt, wobei die Gesamtdauer der Bestrahlung in etwa konstant bleibt (alle anderen Parameter sind wie bei dem bekannten Verfahren). Der in der Fig. 2A im Querschnitt gezeigte Ausschnitt aus einer Projektionsmaske 11 mit einem transparenten Bereich 12, soll -wiederum der besseren Anschaulichkeit halber im Verhältnis 1:1 - dabei in die Photolackschicht 15 auf dem Strubstrat 13 übertragen werden. Die Fig. 2A zeigt in einer Querschnittsdarstellung bereits das Ergebnis dieser Operation, nämlich eine Öffnung 16 mit geneigten Wänden in der Photolackschicht 15. Die Öffnung 16 hat unten die selben Abmessungen wie der transparente Bereich 12. Erreicht wird die Neigung der Wände durch die zusätzliche ganzflächige Bestrahlung der Photolackschicht 15. In dem in der Fig. 2B gezeigten Diagramm sind die Intensitäten (21 bzw. 22) der bildmäßigen und der ganzflächigen Bestrahlung entlang dem in der Fig. 2A gezeigten Querschnitt aufgetragen. Durch die ganzflächige Bestrahlung werden auch die durch die Maske abgeschatteten Bereiche der Photolackschicht 15 entsprechend der Intensität der ganzflächigen Bestrahlung löslich. Für die in der Fig. 2b zugrunde gelegten Intensitäten ergibt sich eine Löslichkeit des Photolacks entlang des in der Fig. 2A gezeigten Querschnitts, wie sie in dem in der Fig. 2C gezeigten Diagramm aufgetragen ist.

Das Diagramm in der Fig. 2C zeigt, daß als Folge der doppelten Bestrahlung der Photolack nicht nur in den durch die transparenten Bereiche in der Projektionsmaske definierten Bereichen sondern insgesamt zumindest etwas löslich wird. Dies ist in der Fig. 2A veranschaulicht, in der die gestrichelte Linie 14 die ursprüngliche Oberfläche der Photolackschicht 15 bezeichnet. Ist es erforderlich, daß das entwickelte Photolackmuster eine bestimmte Dicke hat, so muß diese Schrumpfung bei der Festlegung der Anfangsdicke der Photolackschicht 15 unter Berücksichtigung der angewandten Strahlungsintensitäten einkalkuliert werden. Derartige Kalkulationen liegen innerhalb des Rahmens fachmännischen Handelns. Komplexer ist jedoch die Wirkung der zusätzlichen ganzflächigen Bestrahlung im Bereich der Wände der Öffnungen in der Photolackschicht 15. Während, wenn nur bildmäßig bestrahlt wird, die zu Beginn der Entwicklung konische Vertiefung wegen der vernachlässigbaren Löslichkeit in den von der Projektionsmaske abgeschatteten Bereichen allmählich in eine zylindrische Vertiefung mit einem Grundriß entsprechend den zugehörigen transparenten Bereichen der Projektionsmaske übergeht, kann sich, wenn zusätzlich ganzflächig bestrahlt wird, beim Entwickeln die zylindrische Form nicht ausbilden, weil wegen der endlichen Löslichkeit in den abgeschatteten Photolackbereichen die Entwicklungsfront in etwa mit der Neigung, die sich einstellt, wenn der Querschnitt der entwickelten Öffnung in halber Höhe so groß ist wie ihr zugehöriger transparenter Bereich in der Projektionsmaske ist, in das abgeschattete Gebiet hinein fortschreitet.

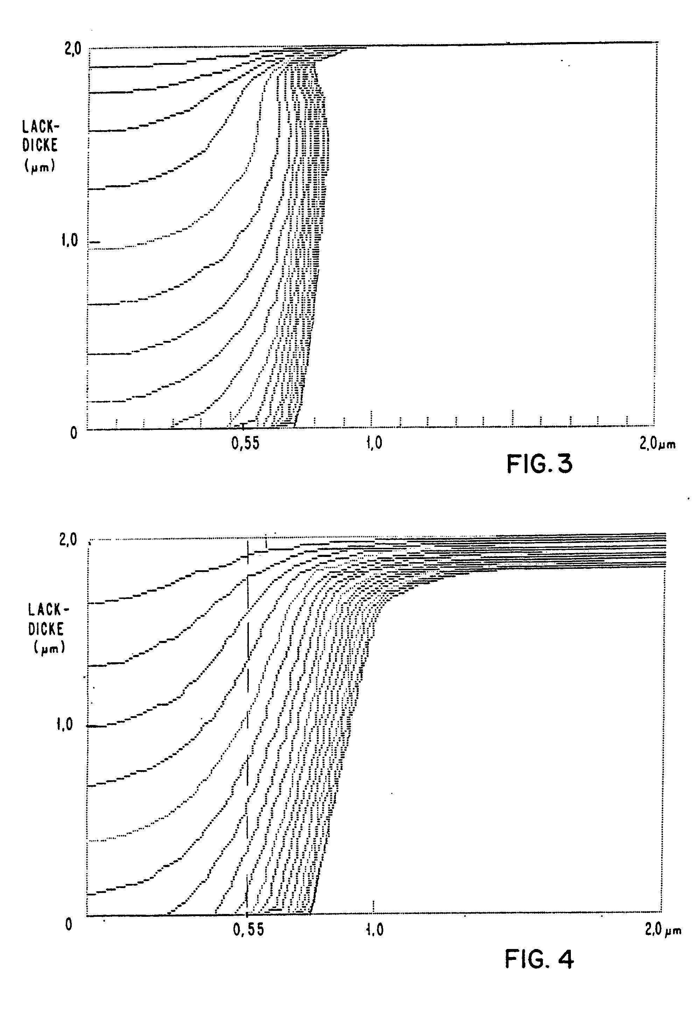

Die gewünschte Neigung der Öffnungswände in dem Photolackmuster wird durch entsprechende Festlegung des Intensitätsverhältnisses von bildmäßiger und ganzflächiger Bestrahlung eingestellt. In den Fig. 3 bis 5 sind für die Intensitätsverhältnisse 1:0, d.h. nur bildmäßige Bestrahlung (Stand der Technik), 1:0,14 und 1:0,29 die Entwicklungsfronten in einer Photolackschicht die bildmäßig durch einen 1 µm breiten transparenten Bereich der Projektionsmaske bestrahlt worden war, im Abstand von 5 Sekunden aufgetragen. Dabei werden Neigungswinkel von ungefähr 90, ungefähr 80 bzw. ungefähr 73° C erhalten.

Zu den bei der Wellenlänge 435 nm transparenten Positivlacken gehören die von der Firma Shipley angebotenen, z.B. der unter der Typenbezeichnung Microposit 1450J vertriebene Lack. Dieser Lack enthält ein Phenol-Formaldehyd-Harz und einen Diazonaphtochinon-Inhibitor. Er wird üblicherweise vor dem Bestrahlen 20 Minuten lang bei 85° C und nach dem Bestrahlen 10 Minuten bei 105° C gehärtet. Bei Verwendung eines Projektionsbelichtungsgeräts mit einer numerischen Appertur von 0,30, das bei der Projektion das zu übertragende Muster im Verhältnis 5:1 verkleinert, wird die - ungefähr 2 $\mu$m dicke - Photolackschicht mit Strahlung, die eine Wellenlänge von 435 nm und eine Energie von 320 mW/cm$^2$ hat, bildmäßig zwischen 0,2 und 2,0 Sekunden und ganzflächig zwischen 0,05 und 1,0 Sekunden bestrahlt. Entwickelt wird dieser Lacke bevorzugt mit dem von der Firma Shipley unter dem Handelsnamen Microposit-Entwickler angebotenen Produkt, welches Natriummetasilikat und Natriumphosphate enthält, oder mit einer Kaliumhydroxidlösung (0,15 bis 0,2 normal) bei ungefähr 26° C.

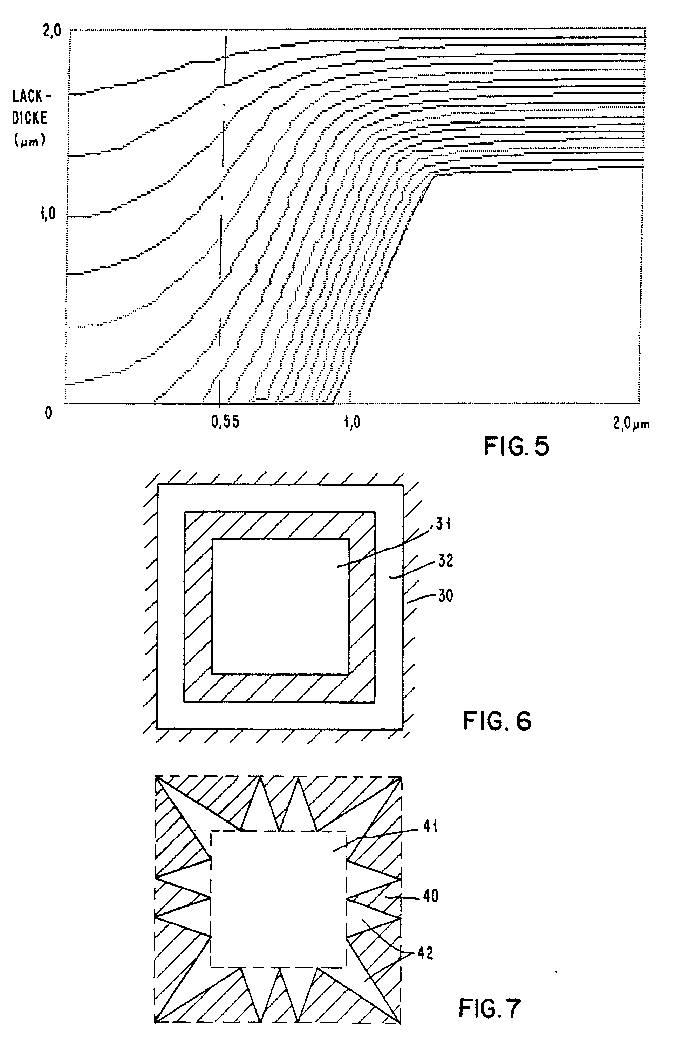

Bei der zweiten Ausgestaltung des erfindungsgemäßen Verfahrens wird nur einmal dafür mit einer speziell ausgebildeten Maske bestrahlt. Bei einer ersten Ausführungsform dieser Ausgestaltung werden die transparenten Musterelemente in der Projektionsmaske mit einem transparenten Rahmen festgelegter Breite in einem festgelegten Abstand (beide Maße bevorzugt etwa 2 $\mu$m) umgeben. Die Fig. 6 zeigt in schematischer Darstellung eine Aufsicht auf ein solches transparentes Musterelement 31 und den zugehörigen Rahmen 32 in einer Projektionsmaske 30.

Zur Einstellung eines gewünschten Neigungswinkels der Öffnungswände in dem Photolackmuster erfolgt über eine entsprechende Festlegung der Breite des Rahmens 32 und seines Abstands vom zugehörigen Musterelement 31. Die Breite des Rahmens 32 ist dadurch nach oben begrenzt, daß er durch die Optik der verwendeten Projektionseinrichtung nicht mehr aufgelöst werden darf. Wenn der Ring auch nicht aufgelöst wird, so erzeugt er doch Streulicht, welches sich dem an den Kanten der bildmäßig zu übertragenden transparenten Bereiche entstehenden Streulicht überlagert, wodurch eine Bestrahlung der dem Kantenbereich benachbarten durch die Maske abgeschatteten Gebiete erreicht wird, aus der eine Löslichkeit dieser Gebiete im Entwickler resultiert, welche beim Entwickeln die Ausbildung von geneigten Öffnungswänden bewirkt.

Zur Erzeugung des zusätzlichen Streulichts ist es auch - wie die Fig. 7 zeigt - möglich, statt eines transparenten Rahmens um die zu übertragenden transparenten Bereiche 41 in der Projektionsmaske 40 sternförmige Ausbuchtungen 42 der Ränder der zu projizierenden transparenten Bereiche 41 vorzusehen. Auch diese Ausbuchtungen 42 müssen so gestaltet sein, daß sie durch die Optik der Projektionseinrichtung nicht aufgelöst werden.

Die erfindungsgemäß hergestellten Photolackmuster wurden beim selektiven Entfernen des darunterliegenden Substrats mittels eines Trockenätzprozesses als ctzmaske eingesetzt. Die Wände der dabei erzeugten Löcher haben im wesentlichen dieselben Neigungswinkel wie die zugehörigen Öffnungen in dem Photolackmuster.

Im folgenden sollen anhand von Ausführungsbeispielen die erste der beschriebenen Ausgestaltungen des erfindungsgemäßen Verfahrens noch weiter verdeutlicht werden.

Bei jedem der folgenden Ausführungsbeispiele wurden jeweils 5 Proben prozessiert. Als Proben wurden mit Photolack beschichtete Substrate verwendet. Der verwendete Photolack war der Microposit-1450J von der Firma Shipley. Die Dicke der Photolackschicht betrug jeweils ungefähr 2 $\mu$m. Für das Substrat wurde ein Material ausgewählt, welches mit einem Verfahren trockengeätzt werden kann, bei welchem der Photolack nicht wesentlich angegriffen wird. Jeweils vor und nach dem Bestrahlen wurden die Proben erhitzt und zwar vor dem Bestrahlen 20 Minuten lang auf 85° C und nach dem Bestrahlen 10 Minuten lang auf 105° C. Bestrahlt wurde sowohl bildmäßig als auch ganzflächig mit dem von der Firma GCA unter der Typenbezeichnung DSW 6300 vertriebenen Projektionsbelichtungsgerät bei einer Wellenlänge von 435 nm und einer Energie von 320 mW/cm$^2$. Das Projektionsbelichtungsgerät hat eine numerische Appertur von 0,3 und bei der bildmäßigen Bestrahlung wird die Bestrahlungsmaske im Verhältnis 5:1 verkleinert auf die Positivlackschicht projiziert. bertragen auf die Photolackschicht wurden jeweils quadratische Musterelemente mit 1 und 2 $\mu$m Kantenlänge, d.h. die transparenten Bereiche in den Projektionsmasken hatten 5 und 10 $\mu$m Kantenlänge. Entwickelt wurde bei 26° C mit dem Microposit-Entwickler der Firma Shipley, welcher 1:1 mit Wasser verdünnt war, d.h. ungefähr 0,11 molar an Natriummetasilikat und ungefähr 0,06 molar an Natriumphosphaten war.

Die Parameter, welche bei den einzelnen Ausführungsbeispielen sich unterschieden, und die erzielten Ergebnisse sind in der Tabelle aufgelistet.

**TABELLE**

**Ergebnisse nach Entwickeln**

| Beisp. Nr. | Bestrahlungsdauer (in sec.) bildmäßig | ganzfl. | Entwickl.-dauer | ungefähre Lackdicke (µm) | Neigungswinkel der Öffnungswände |
|---|---|---|---|---|---|
| 1 | 0,8 | – | 90 sec | 2,0 | 90° |
| 2 | 0,7 | 0,1 | 90 sec | 1,8 | 80° |
| 3 | 0,62 | 0,18 | 90 sec | 1,3 | 73° |
| 4 | 0,51 | 0,29 | 90 sec | 0,8 | 60° |

Beim Beispiel 1 wurde entsprechend dem Stand der Technik vorge gangen. In der Fig. 3 ist die Veränderung des Randprofils einer etwa 1 µm großen Öffnung während des Entwickelns veranschaulicht. Die einzelnen Kurven veranschaulichten, wie sich das Randprofil in 5 Sekunden- Abständen verändert. Die Fig. zeigt den fast senkrechten Verlauf der Öffnungswände, wenn die Entwicklung durch die ganze Dicke der Photolackschicht hindurchgeschritten ist, und daß in den nicht bestrahlen Bereichen sich die Dicke des Photolacks nach dem Entwickeln praktisch nicht verändert.

Bei den Beispielen 2 bis 4 wurde außer bildmäßig auch noch ganzflächig bestrahlt. Die Figuren 4 und 5 zeigen analog der Fig. 3 die Veränderung des Wandprofils eines 1 $\mu$m großen Loches während des Entwickelns bei den Beispielen 2 bzw. 3. Den Figuren ist zu entnehmen, welcher Neigungswinkel und welche Photolackschichtdicke sich beim Entwickeln einstellt.

Bei allen Beispielen war die Reproduzierbarkeit sehr gut.

Das im Beispiel 4 hergestellte Photolackmuster, welches auf einer 0,5 $\mu$m dicken SiO$_2$-Schicht aufgebracht war, wurde beim selektiven Abtragen der SiO$_2$-Schicht mittels reaktiven Ionenätzens in einer CF$_4$ Atmosphäre als Ätzmaske verwendet. Dabei wurde der Neigungswinkel (60°) der Öffnungswände in dem Photolackmuster auf die Wände der geätzten Löcher in der SiO$_2$-Schicht übertragen. Nach dem Entfernen des Photolackmusters wurde die SiO$_2$-Schicht mit einer 70 nm dicken Alumiumschicht bedampft. Messungen ergaben, daß die Dicke der Aluminiumschicht - einschließlich des Bereichs der Lochkanten - einheitlich war.

**Ansprüche**

1.  Verfahren zum Herstellen von Mustern aus positivem Photolack, wobei eine Schicht aus dem Photolack in einem Projektionsbelichtungsgerät bildmäßig, mit einer Strahlung, für die der Photolack stark durchlässig ist, bestrahlt und mit einem basischen Entwickler behandelt wird, dadurch gekennzeichnet, daß mindestens die Gebiete der Photolackschicht, die an die der bildmäßigen Bestrahlung ausgesetzten Bereiche angrenzen, zusätzlich mit der genannten Strahlung bestrahlt werden.

2.  Verfahren nach Patentanspruch 1, dadurch gekennzeichnet, daß die Photolackschicht (15) ganzflächig zusätzlich bestrahlt wird.

3.  Verfahren nach Patentanspruch 1 oder 2, dadurch gekennzeichnet, daß über das Verhältnis der Intensitäten von bildmäßiger und ganzflächiger Bestrahlung der Neigungswinkel der Wände in den Öffnungen der entwickelten Photolackschicht (15) gesteuert wird.

4.  Verfahren nach Patentanspruch 3, dadurch gekennzeichnet, daß das Verhältnis der Intensitäten von bildmäßiger und ganzflächiger Bestrahlung zwischen 1,5 und 13 liegt.

5.  Verfahren nach einem der Ansprüche 1 bis 4, dadurch gekennzeichnet, daß Öffnungen (16) in der Photolackschicht erzeugt werden, deren Abmessungen im $\mu$m-Bereich oder darüber liegen.

6.  Verfahren nach einem der Ansprüche 1 bis 5, dadurch gekennzeichnet, daß zum Erzeugen von 1 bis 2 $\mu$m großen Öffnungen (16) eine ungefähr 2 $\mu$m dicke Schicht (15) aus einem positiven Photolack auf der Basis eines Phenol-Formaldehyd-Harzes als Filmbildner und eines Diazonaphtochinonsensibilisators als strahlungsempfindliche Komponente mit einer Strahlung, die eine Wellenlänge von 435 nm und eine Energie von 380 mW/cm$^2$ hat, insgesamt (bildmäßig und ganzflächig) zwischen 0,25 und 3 Sekunden bestrahlt, davor 1 bis 30 Minuten lang auf 50 bis 85° C und anschließend 1 bis 10 Minuten lang auf 70 bis 110° C erhitzt und schließlich mit einer Lösung, welche ungefähr 0,1 bis 0,2 molar an Natriummetasilikat und 0 bis 0,1 molar an Phosphaten ist, 1 bis 10 Minuten lang bei 15 bis 30° C entwickelt wird.

7.  Verfahren nach Patentanspruch 1, dadurch gekennzeichnet, daß zum bildmäßigen Bestrahlen eine Projektionsmaske (20) verwendet wird, bei der durch eine entsprechende Ausgestaltung der an die transparenten Bereiche angrenzenden Gebiete eine auf die Photolackschicht einwirkende Streustrahlung erzeugt wird.

8.  Verfahren nach Patentanspruch 7, dadurch gekennzeichnet, daß eine Projektionsmaske (30) verwendet wird, bei der die bildmäßig zu übertragenden transparenten Bereiche (31) in einem festgelegten Abstand mit einem transparenten

EP 0 227 851 B1

Ring (32) festgelegter Breite umgeben ist, der bei der Projektion nicht mehr aufgelöst wird.

9.  Verfahren nach Patentanspruch 8,
    dadurch gekennzeichnet, daß bei Zugrundelegung einer Projektionsmaske (30), die beim Projizieren im Verhältnis 5:1 verkleinert wird, die transparenten Bereiche (31) in der Maske im Abstand von ungefähr 2 μm mit einem ungefähr 2 μm breiten transparenten Ring (32) umgeben sind.

10. Verfahren nach Patentanspruch 7,
    dadurch gekennzeichnet, daß eine Projektionsmaske (40) verwendet wird, in welcher die Ränder der zu projizierenden transparenten Bereiche (41) sternförmig ausgebuchtet sind, wobei die Ausbuchtungen bzw. Spitzen (43) bei der Projektion nicht mehr aufgelöst werden.

## Claims

1.  Process for producing patterns of positive photoresist, comprising the steps of image-irradiating a layer of said photoresist in a projection exposure system, using a radiation to which the photoresist is highly transparent, and treating said layer of said photoresist with a basic developer, characterized in that at least the regions of the photoresist layer adjoining the image-irradiated regions are additionally irradiated by said radiation.

2.  Process according to patent claim 1,
    characterized in that the photoresist layer (15) is additionally blanket-irradiated.

3.  Process according to patent claim 1 or 2,
    characterized in that the inclination angles of the walls in the holes of the developed photoresist layer (15) are controlled by the ratio of the intensities of image and blanket irradiation.

4.  Process according to patent claim 3,
    characterized in that the ratio of the intensities of image and blanket irradiation is between 1.5 and 13.

5.  Process according to any one of the claims 1 to 4,
    characterized in that the holes (16), whose dimensions are within or above the μm range, are generated in the photoresist layer.

6.  Process according to any one of the claims 1 to 5,
    characterized in that for generating 1 to 2 μm holes (16), an about 2 μm thick layer (15) of a positive photoresist on the basis of a phenolformaldehyde resin as a film former and a diazonaphthoquinone sensitizer as a radiation sensitive component is (image and blanket) irradiated, using a radiation having a wavelength of 435 nm and an energy of 380 mW/cm$^2$, for a total time of between 0.25 and 3 seconds, after having previously been heated to 50 to 85° C for 1 to 30 minutes and subsequently been heated to 70 to 110° C for 1 to 10 minutes, and finally developed for 1 to 10 minutes at 15 to 30° C, using a solution that has about 0.1 to 0.2 mole of sodium metasilicate and 0 to 0.1 mole of phosphates.

7.  Process according to patent claim 1,
    characterized in that for image irradiation, a projection mask (20) is used wherein, by suitably structuring the regions adjoining the transparent regions, a stray radiation acting on the photoresist layer is produced.

8.  Process according to patent claim 7,
    characterized in that a projection mask (30) is used, wherein the transparent regions (31), whose image is to be transferred, are surrounded at a predetermined distance by a transparent ring (32) of fixed width which is no longer resolved during projection.

9.  Process according to patent claim 8,
    characterized in that based upon a projection mask (30), which during projection is reduced at a ratio of 5:1, the transparent regions (31) in the mask are surrounded at a distance of about 2 μm by an about 2

μm wide transparent ring.

**10.** Process according to patent claim 7,
characterized in that a projection mask (40) is used in which the edges of the transparent regions (41) to be projected have star-shaped projections and/or spikes (43) that are no longer resolved during projection.

**Revendications**

**1.** Procédé pour fabriquer des structures formées d'une laque photosensible de type positif et selon lequel on irradie, conformément à une image, une couche formée d'une laque photosensible dans un appareil d'exposition par projection, avec un rayonnement, pour lequel la laque photosensible est très transparente, et on traite cette couche avec un révélateur basique, caractérisé en ce qu'on irradie en outre avec ledit rayonnement au moins les zones de la couche de laque photosensible, qui jouxtent les régions soumises à l'irradiation effectuée conformément à l'image.

**2.** Procédé selon la revendication 1, caractérisé en ce qu'on irradie en outre la couche de laque photosensible (15) sur toute sa surface.

**3.** Procédé selon la revendication 1 ou 2, caractérisé en ce qu'on commande l'angle d'inclinaison des parois présentes dans les ouvertures de la couche de laque photosensible développée (15), au moyen du rapport des intensités de l'irradiation effectuée conformément à l'image et de l'irradiation effectuée sur toute la surface.

**4.** Procédé suivant la revendication 3, caractérisé par le fait que le rapport des intensités de l'irradiation effectuée conformément à l'image et de l'irradiation effectuée sur toute la surface est compris entre 1,5 et 13.

**5.** Procédé selon l'une des revendications 1 à 4, caractérisé en ce qu'on aménage, dans la couche de laque photosensible, des ouvertures (16), dont les dimensions sont de l'ordre du micron ou plus.

**6.** Procédé selon l'une des revendications 1 à 5, caractérisé en ce que pour produire des ouvertures (16), d'une taille de 1 à 2 μm, on expose une couche (15) d'une épaisseur d'environ 2 μm, formée d'une laque photosensible à effet positif réalisée à base d'une résine phénolformaldéhyde en tant que système de formation d'une pellicule et d'un sensibilisateur formé de diazonaphtoquinone en tant que composé sensible au rayonnement, à un rayonnement qui possède une longueur d'onde égale à 435 nm et une énergie de 380 mW/cm², et ce globalement (conformément à l'image et sur toute la surface) pendant une durée comprise entre 0,25 et 3 secondes après un chauffage réalisé pendant 1 à 30 minutes à une température comprise entre 50 et 85 °C, puis pendant 1 à 10 minutes à une température comprise entre 70 et 110 °C, et on la développe ensuite pendant une durée de 1 à 10 minutes à une température comprise entre 15 et 30 °C, en utilisant une solution qui présente un taux molaire compris approximativement entre 0,1 et 0,2 en métasilicate de sodium et un taux molaire compris approximativement entre 0 et 0,1 en phosphates.

**7.** Procédé selon la revendication 1, caractérisé en ce que pour l'irradiation conformément à l'image, on utilise un masque de projection (20), avec lequel on produit un rayonnement diffusé agissant sur la couche de laque photosensible, au moyen d'une configuration correspondante des zones jouxtant les régions transparentes.

**8.** Procédé selon la revendication 7, caractérisé en ce qu'on utilise un masque de projection (30), dans lequel les zones transparentes (31), qui doivent être transmises conformément à l'image, sont entourées, à une distance fixée, par un anneau transparent (32) possédant une largeur fixée, qui n'est plus distinguée lors de la projection.

**9.** Procédé selon la revendication 8, caractérisé en ce que, lorsqu'on prend pour base un masque de projection (30) qui, lors de la projection, réalise une réduction dans le rapport 5:1, les zones transparentes (31) du masque sont entourées, à une distance d'environ 2 μm, par un anneau

transparent (32) possédant une largeur égale à environ 2 μm.

10. Procédé selon la revendication 7, caractérisé en ce qu'on utilise un masque de projection (40), dans lequel les bords des zones transparentes (41) devant être projetées sont dentelés en forme d'étoile, les indentations ou les pointes (43) n'étant plus distinguées lors de la projection.

FIG.1A

FIG.1B

FIG.1C

FIG.2A

FIG.2B

FIG.2C

LACK-
DICKE
(µm)

2,0

1,0

0

0,55          1,0                    2,0 µm

FIG. 3

LACK-
DICKE
(µm)

2,0

1,0

0

0,55          1,0                    2,0 µm

FIG. 4

14

FIG. 5

FIG. 6

FIG. 7